# EUROPEAN PATENT APPLICATION

(11) **EP 4 440 272 A1**
(43) Date of publication of application: **02.10.2024**
(21) Application number: 24163566.3
(22) Date of filing: 14.03.2024
(51) Int. Cl.: H05K 7/20

(54) **BUSBAR UNIT**

(30) Priority: 22.03.2023 JP 2023045410
(71) Applicant: TOYOTA JIDOSHA KABUSHIKI KAISHA, Toyota-shi, Aichi-ken, 471-8571 (JP)
(72) Inventor: OBATA, Tatsuo, Toyota-shi, Aichi-ken, 471-8571 (JP); YONOMOTO, Shunya, Toyota-shi, Aichi-ken, 471-8571 (JP); HONDA, Tatsuki, Toyota-shi, Aichi-ken, 471-8571 (JP); INATA, Kazunari, Toyota-shi, Aichi-ken, 471-8571 (JP); OKAMOTO, Shotaro, Toyota-shi, Aichi-ken, 471-8571 (JP); MAKINO, Akihiro, Toyota-shi, Aichi-ken, 471-8571 (JP)
(74) Representative: Cabinet Beau de Loménie

(57) **Abstract**

A busbar unit (60, 70) may include a busbar (62, 64) through which an electric current flows; and a cover (66, 78) covering an intermediate part of the busbar (62, 64, 72, 74,76). The cover (66, 78) may include a passage along the intermediate part of the busbar (62, 64), a coolant for a vehicle flowing in the passage.

## Description

### REFERENCE TO RELATED APPLICATION

This application claims priority to Japanese Patent Application No. 2023-045410 filed on March 22, 2023. The entire content of the priority application is incorporated herein by reference and the person skilled in the art can refer to the priority application when considering the present disclosure.

### BACKGROUND ART

The disclosure herein relates to a busbar unit.

Japanese Patent Application Publication No. 2020-103031 describes an electric assembly in which an electric busbar is attached to a cooling module including a coolant inlet and a coolant outlet. The electric busbar is attached to a receptacle that protrudes from a first portion including the coolant inlet and the coolant outlet.

### DESCRIPTION

In the electric assembly above, the electric busbar is located apart from the first portion including the coolant inlet and the coolant outlet. Therefore, the electric busbar may not be able to efficiently release its heat to the coolant.

The disclosure herein provides a technology that allows heat of a busbar to be efficiently released to a coolant.

A first aspect disclosed herein relates to a busbar unit. The busbar unit may comprise a busbar through which an electric current flows; and a cover covering an intermediate part of the busbar. The cover may comprise a passage along the intermediate part of the busbar. A coolant for a vehicle may flow in the passage.

This configuration allows the coolant to flow along the intermediate part of the busbar. Thus, heat of the busbar can be efficiently released.

Details and further improvements of the technology disclosed herein are described below.

### BRIEF DESCRIPTION OF THE DRAWINGS

FIG. 1 shows a side view of an electric-powered vehicle on which a drive unit according to an embodiment is mounted.
FIG. 2 shows a side view of the drive unit with a casing removed.
FIG. 3 shows a schematic internal structure of the drive unit.
FIG. 4 shows a plan view of the drive unit.
FIG. 5 shows a bottom view of the drive unit.
FIG. 6 shows a side view of the drive unit for explaining a configuration of a busbar unit.
FIG. 7 shows a perspective view of the busbar unit.
FIG. 8 shows a perspective view of the busbar unit.
FIG. 9 shows a block diagram of a configuration of a cooling circuit.

### DETAILED DESCRIPTION

In a second aspect disclosed herein according to the first aspect, the coolant flowing in the passage may be used for cooling a power module mounted on the vehicle.

With this configuration, there is no need to separately provide the coolant flowing in the passage of the cover.

In a third aspect disclosed herein according to the first or second aspect, the busbar unit may be used in an inverter used for controlling a drive motor of the vehicle. The inverter may comprise a power module including a plurality of switching elements, a smoothing capacitor, and a noise filter. The power module, the smoothing capacitor, and the noise filter may be arranged in this order from an upper side to a lower side. The passage may be arranged to extend from the upper side toward the lower side.

This configuration allows the coolant in the passage to flow from the upper side to the lower side. This configuration thus allows the coolant in the passage to flow smoothly.

In a fourth aspect disclosed herein according to the third aspect, the busbar unit may be housed in a casing that covers the inverter. The outlet through which the coolant flows out from the passage may be open to an outside of the casing.

This configuration allows the coolant to be directly flowed out from the passage to the outside of the casing covering the inverter.

In a fifth aspect disclosed herein according to one of the first to fourth aspects, the busbar and the cover may be curved along a shaft of a drive motor of the vehicle.

The shapes of the busbar and the cover allow for efficient use of the space in the vehicle.

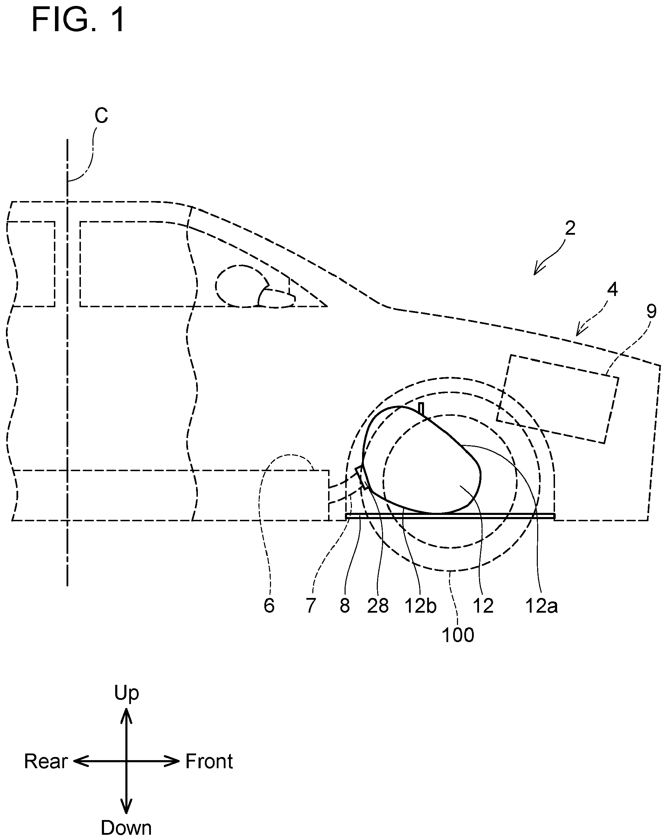

FIG. 1 shows a schematic side view of a front portion of an electric-powered vehicle 2 on which a drive unit 10 according to an embodiment is mounted. The electric-powered vehicle 2 includes, in addition to the drive unit 10, a body 4, a battery pack 6, a suspension member 8, and a pair of front wheels 100. A plurality of devices for operation of the electric-powered vehicle 2, such as a pair of rear wheels, a control device, etc., is mounted on the electric-powered vehicle 2, although they are not shown. In FIG. 1, components other than the drive unit 10 and the suspension member 8 are depicted by broken lines for easier understanding. Further, for an easier view of the drawing, contours of the components are shown in a simplified manner. The electric-powered vehicle 2 comprises any vehicle that uses an electric motor for at least a part of its traction, such as a hybrid vehicle, a fuel cell vehicle, etc., as well as an electric-powered vehicle. Hereinafter, "up", "down", "left", "right", "front", and "rear" are based on the directional indicators in the drawings.

### Configuration of Drive Unit

The drive unit 10 is located frontward of a front seat (not shown) of the electric-powered vehicle 2. The drive unit 10 is disposed in a compartment located frontward of a cabin space in which passengers ride in the electric-powered vehicle 2. The drive unit 10 is located between the pair of front wheels 100 located at respective ends of the electric-powered vehicle 2 in a left-right direction. The drive unit 10 is located rearward of a front trunk 9 which is located near the front end of the electric-powered vehicle 2. The front trunk 9 is a space that is separate from the cabin space and can house luggage therein. The drive unit 10 is located frontward of a vehicle center C of the electric-powered vehicle 2 in a front-rear direction.

The drive unit 10 is fixed to the suspension member 8. The suspension member 8 is a part of a suspension unit (not shown) including springs, dampers, etc. disposed for the respective front wheels 100. The suspension member 8 supports the springs, dampers, etc. Thus, the suspension unit is mounted on the electric-powered vehicle 2.

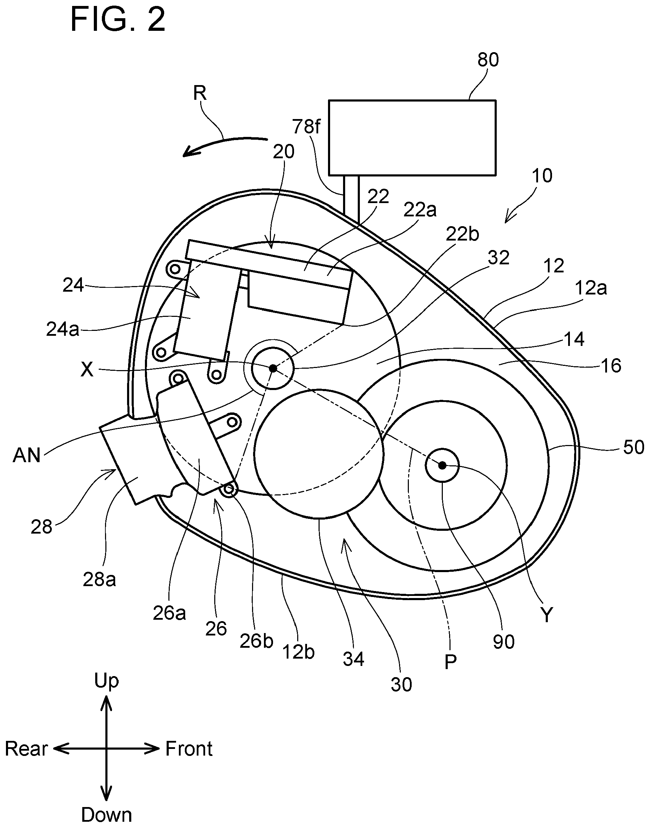

The drive unit 10 is protected by a casing 12. FIG. 2 shows a right-side view of the inside of the casing 12 with a right wall of the casing 12 removed. The drive unit 10 includes, other than the casing 12, a motor 14, a gear unit 30, an inverter 20, and a drive shaft 90.

The casing 12 houses the motor 14, the gear unit 30, the inverter 20, and the drive shaft 90. The casing 12 defines a housing space in which multiple components are assembled together.

In the drive unit 10, the inverter 20 converts DC power from the battery pack 6 to AC power suitable for driving the motor 14. The battery pack 6 is located below a floor panel (not shown) of the electric-powered vehicle 2. The battery pack 6 supplies electric power to the drive unit 10. The drive unit 10 thereby drives the pair of front wheels 100. Further, the drive unit 10 also functions as an electricity generator. The battery pack 6 stores electric power supplied from the drive unit 10.

The inverter 20 supplies the AC power to the motor 14. The motor 14 is driven with the AC power from the inverter 20. The torque of the motor 14 is transmitted to the drive shaft 90 through the gear unit 30. The drive shaft 90 transmits the torque of the motor 14 to each of the front wheels 100 to rotate the pair of front wheels 100. Thus, the electric-powered vehicle 2 is driven. The inverter 20 converts AC power generated by the motor 14 to DC power and supplies it to the battery pack 6.

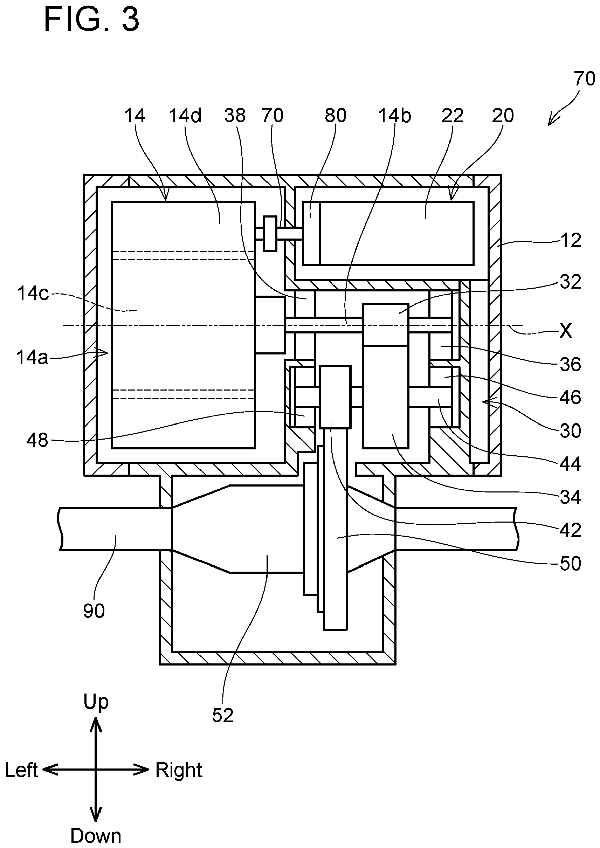

The motor 14 is located in an upper rear portion of the drive unit 10. FIG. 3 shows an internal structure of the drive unit 10 as viewed from its lower front portion toward the upper rear portion. In FIG. 3, the depiction of the inverter 20 is partially omitted for illustration of the gear unit 30. The motor 14 includes a body 14a including a rotor 14c and a stator 14d, and a motor shaft 14b extending from the rotor 14c. The stator 14d has a cylindrical shape. The stator 14d includes a stator core including a plurality of teeth and coils disposed on the plurality of teeth, although they are not shown. The rotor 14c is located inward of the stator 14d. The outer circumferential surface of the rotor 14c faces the inner circumferential surface of the stator 14d. The rotor 14c includes a plurality of permanent magnets on its outer circumferential surface, which are arranged such that polarities switch alternately in the circumferential direction of the rotor 14c. When the AC power from the inverter 20 is supplied to each coil of the stator 14d, a magnetic field generated at the stator 14d changes. The rotor 14c thereby rotates. The motor shaft 14b is coaxial with the rotation center of the rotor 14c. The motor shaft 14b extends from the body 14a linearly and rightward.

### Configuration of Gear Unit

The torque generated by the motor 14 is transmitted to the gear unit 30 through the motor shaft 14b. The gear unit 30 includes a shaft gear 32, a counter gear 34, a counter gear 42, a ring gear 50, a differential gear 52, and a shaft 44. Each of the shaft gear 32, the counter gear 34, the counter gear 42, and the ring gear 50 has a cylindrical shape with a plurality of teeth disposed on its outer circumferential surface. The teeth of the shaft gear 32, the counter gear 34, the counter gear 42, and the ring gear 50 are not shown. The shaft gear 32 is attached to the motor shaft 14b. The motor shaft 14b is supported by bearings 36, 38 attached to the casing 12 such that it is rotatable with respect to the casing 12. The gear unit 30 directly contacts the motor 14 in the drive unit 10, which allows the gear unit 30 and the motor 14 to be mechanically connected to each other easily.

The counter gear 34 meshes with the shaft gear 32 and rotates as the shaft gear 32 rotates. The counter gear 34 is located below and frontward of the shaft gear 32. The counter gear 34 is attached to the shaft 44. The shaft 44 is parallel to the motor shaft 14b. The shaft 44 is located below and frontward of the motor shaft 14b. The shaft 44 is supported by bearings 46, 48 attached to the casing 12 such that it is rotatable with respect to the casing 12. The counter gear 42 is attached to the shaft 44. Thus, the counter gear 42 is coaxially coupled to the counter gear 34. The counter gear 42 rotates as the counter gear 34 rotates. The ring gear 50 meshes with the counter gear 42 and rotates as the counter gear 42 rotates.

The ring gear 50 is located below and frontward of the counter gear 42. The ring gear 50 rotates about a center axis Y (see FIG. 2). The ring gear 50 is attached to the differential gear 52. The differential gear 52 rotates as the ring gear 50 rotates. The differential gear 52 is a gear mechanism that rotates the pair of front wheels 100 independently by the rotation of the ring gear 50. The differential gear 52 is located below and frontward of the ring gear 50. The differential gear 52 drives the drive shaft 90. The drive shaft 90 is located below and frontward of the shaft 44. When the rotation of the motor 14 is transmitted to the drive shaft 90, the drive shaft 90 rotates about the center axis Y and the pair of front wheels 100 rotates about the drive shaft 90. Thus, the electric-powered vehicle 2 travels.

As described, the counter gear 34 is located below and frontward of the shaft gear 32. The counter gear 42 is coaxial with the counter gear 34, i.e., they are aligned side by side in the left-right direction. The ring gear 50 is located below and frontward of the counter gear 42. The differential gear 52 is located below and frontward of the ring gear 50. In other words, the differential gear 52, the ring gear 50, the counter gears 42, 34, and the shaft gear 32 are arranged in this order from the lower front toward the upper rear. Thus, as shown in FIG. 1, an upper surface 12a and a lower surface 12b of the casing 12 in which the gear unit 30 is housed are inclined upward from the front toward the rear, i.e., toward the vehicle center C.

A center axis X of the motor shaft 14b (i.e., center axis X of the shaft gear 32) is parallel to the center axis Y of the ring gear 50. As shown in FIG. 2, most of the counter gear 34 is located below a plane P connecting the center axis X of the motor shaft 14b and the center axis Y of the ring gear 50. The counter gear 42 is entirely located below the plane P. In a variant, the counter gear 34 may be entirely located below the plane P. This configuration ensures a space above the gear unit 30. Thus, a device such as the inverter 20, etc. can be disposed above the gear unit 30.

The outer diameter of the counter gear 34 (i.e., the diameter of a circle defined by connecting tips of the teeth arranged on the outer circumference) is larger than the outer diameter of the shaft gear 32. The outer diameter of the ring gear 50 is larger than the outer diameter of the counter gear 42. Thus, the rotational speed of the shaft gear 32 is reduced in two steps. Among the multiple gears 32, 34, 42, 50 of the gear unit 30, the shaft gear 32 has the smallest outer diameter. In a variant, the gear unit 30 may include a gear that is as large as or smaller than the shaft gear 32.

### Configuration of Inverter

As shown in FIG. 1, the inverter 20 is connected to the battery pack 6 via a power cable 7. The inverter 20 converts DC power from the battery pack 6 to AC power suitable for driving the motor 14. The inverter 20 is a high-voltage component to which high-voltage power is applied. Here, "high voltage" means an operating voltage that is greater than DC 60 V and less or equal to 1500 V, or an operating voltage that is greater than AC 30 V (effective value) and less of equal to 1000 V (effective value). The inverter 20 also converts AC power from the motor 14 to DC power suitable for the battery pack 6. In a variant, the inverter 20 converts DC power to AC power, while it may not convert AC power to DC power.

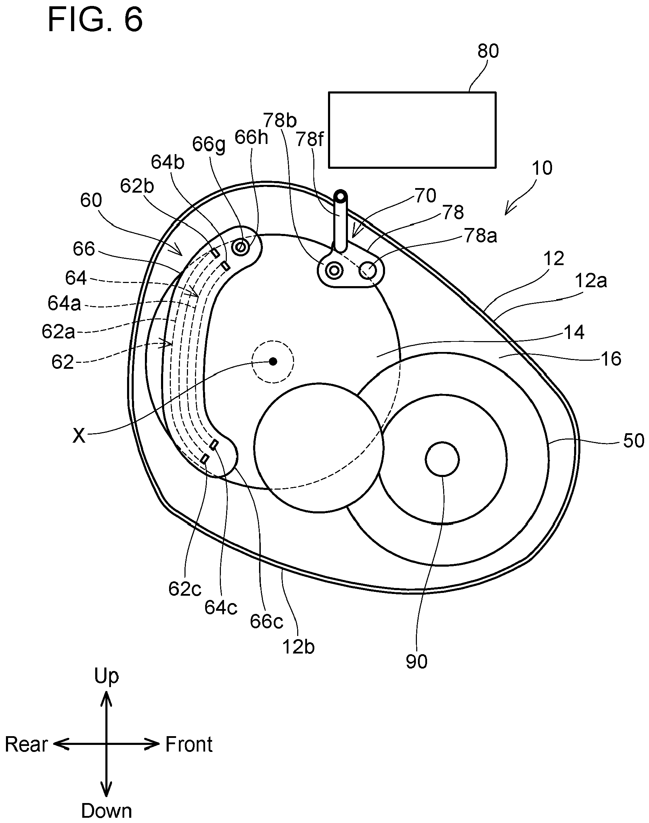

As shown in FIG. 2, the inverter 20 includes a power module 22, a smoothing capacitor 24, a noise filter 26, a connector 28, and busbar units 60, 70 (see FIG. 6). The power from the battery pack 6 is input to the inverter 20 through the connector 28, passes through the noise filter 26, the busbar unit 60, the smoothing capacitor 24, the power module 22, and the busbar unit 70 in this order, and then is supplied to the motor 14 from the busbar unit 70.

The connector 28 includes a terminal (not shown) connected to a terminal of the power cable 7 and a cover 28a surrounding the terminal. The connector 28 penetrates the casing 12 by extending from the outside of the casing 12 to the inside thereof. The terminal extends in the left-right direction and is connected to the power cable 7. As shown in FIG. 2, the cover 28a protrudes downward and rearward from the lower surface 12b of the casing 12. The cover 28a is located in a space below the lower surface 12b. The cover 28a is located below the rear end of the casing 12 and rearward of the lowermost end of the casing 12.

The terminal of the connector 28 extends up to the noise filter 26. The noise filter 26 is a noise filter of electromagnetic compatibility (EMC). The noise filter 26 includes circuit components (not shown), such as a capacitor, a choke coil, etc., and a casing 26a housing the circuit components. The noise filter 26 is housed in the casing 12. The casing 26a is attached to an inner wall of the casing 12. The noise filter 26 is located above and frontward of the connector 28.

The noise filter 26 is connected to the smoothing capacitor 24 via the busbar unit 60. The smoothing capacitor 24 includes a capacitor (not shown) that absorbs voltage fluctuation and a casing 24a housing the capacitor. The smoothing capacitor 24 is housed in the casing 12. The casing 24a is attached to the inner wall of the casing 12. The smoothing capacitor 24 is located above the noise filter 26.

The smoothing capacitor 24 is connected to the power module 22 via a wire. The power module 22 converts the DC power from the battery pack 6 to AC power. The power module 22 supplies the converted AC power to the motor 14. The power module 22 includes multiple combinations of switching elements (not shown) for converting the DC power to three-phase AC power and diodes (not shown). The power module 22 includes a casing 22a housing the multiple combinations of switching elements and diodes. The power module 22 can convert AC power supplied by the motor 14 generating electricity to DC power. The power module 22 is housed in the casing 12. The casing 22a is attached to the inner wall of the casing 12. The power module 22 is located above and frontward of the smoothing capacitor 24.

### Positional Relationships between Motor, Gear Unit, and Inverter

As shown in FIG. 2, the power module 22, the smoothing capacitor 24, and the noise filter 26 are arranged along the outer circumference of the shaft gear 32. As viewed in the left-right direction, i.e., in the direction along the center axis X of the motor shaft 14b, the power module 22, the smoothing capacitor 24, and the noise filter 26 overlap the motor 14. Specifically, edges of the casing 22a of the power module 22, the casing 24a of the smoothing capacitor 24, and the casing 26a of the noise filter 26 partially do not overlap the motor 14.

As viewed in the direction along the center axis X of the motor shaft 14b, 99% of the area of the power module 22, 99% of the area of the smoothing capacitor 24, and 99% of the area of the noise filter 26 overlap the motor 14. In a variant, as viewed in the direction along the center axis X of the motor shaft 14b, the entire area (i.e., 100%) of the power module 22, the entire area of the smoothing capacitor 24, and the entire area of the noise filter 26 may overlap the motor 14. At least one of the power module 22, the smoothing capacitor 24, and the noise filter 26 may overlap the motor 14 over its entire area. Alternatively, as viewed in the direction along the center axis X of the motor shaft 14b, the power module 22, the smoothing capacitor 24, and the noise filter 26 may overlap the motor 14 over 50% to 100% of their areas. As viewed in the direction along the center axis X of the motor shaft 14b, the power module 22, the smoothing capacitor 24, and the noise filter 26 may overlap the motor 14 over at least one of 60% to 100% of their areas, 70% to 100% of their areas, 80% to 100% of their areas, and 90% to 100% of their areas.

The maximum length of the power module 22 in a rotation direction R of the shaft gear 32 is greater than the maximum length thereof in a radial direction of the shaft gear 32. Similarly, the maximum length of the smoothing capacitor 24 in the rotation direction of the shaft gear 32 is greater than the maximum length thereof in a radial direction of the shaft gear 32. Similarly, the maximum length of the noise filter 26 in the rotation direction of the shaft gear 32 is greater than the maximum length thereof in a radial direction of the shaft gear 32. In other words, the power module 22, the smoothing capacitor 24, and the noise filter 26 are arranged such that their longitudinal directions are along the rotation direction of the shaft gear 32 and their short directions are along radial directions of the shaft gear 32.

In the rotation direction of the shaft gear 32, an angle AN between an end 22b of the power module 22 that faces away from the smoothing capacitor 24 and an end 26b of the noise filter 26 that faces away from the smoothing capacitor 24 is greater than or equal to 240 degrees. The angle AN may be greater than or equal to 180 degrees.

The shortest distances from the center axis X to the power module 22, the smoothing capacitor 24, and the noise filter 26 may be substantially equal. Further, the smoothing capacitor 24 and the noise filter 26 are each inclined in the rotation direction R relative to the power module 22. That is, the power module 22, the smoothing capacitor 24, and the noise filter 26 are arranged such that they intersect with each other if extended in their longitudinal directions.

### Configurations of Busbar Units

Referring to FIGS. 6 to 8, the busbar units 60, 70 are described. In FIG. 6, components of the inverter 20, which are shown in the side view of the drive unit 10 in FIG. 2, other than the busbar units 60, 70 are omitted. The busbar unit 60 extends from the noise filter 26 to the smoothing capacitor 24. In the left-right direction, the busbar unit 60 is located between the motor 14 and the noise filter 26 and between the motor 14 and the smoothing capacitor 24. The busbar unit 60 includes two busbars 62, 64 and a cover 66. The busbars 62, 64 are constituted of a conductive material. The two busbars 62, 64 electrically communicate between the noise filter 26 and the smoothing capacitor 24. The busbars 62, 64 include body portions 62a, 64a curved along the rotation direction R of the shaft gear 32, i.e., along the outer circumference of the motor 14, end portions 62b, 64b extending from the body portions 62a, 64a in a bent manner to the smoothing capacitor 24, and end portions 62c, 64c extending from the body portions 62a, 64a in a bent manner to the noise filter 26, respectively.

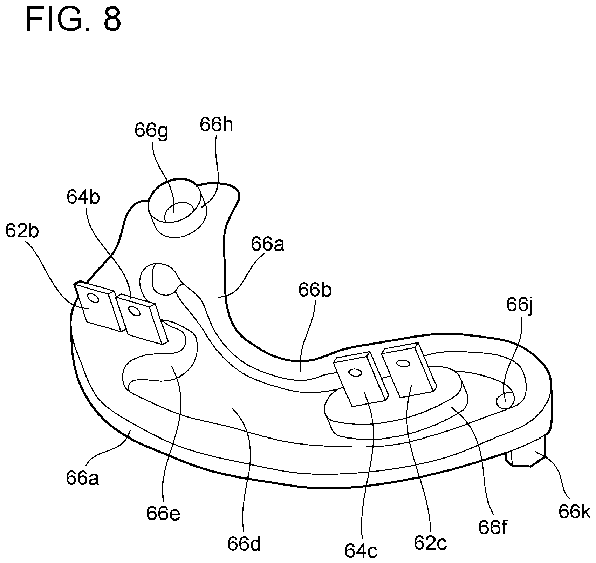

The end portions 62b, 64b are electrically connected to the smoothing capacitor 24. The end portions 62c, 64c are electrically connected to the noise filter 26. The body portions 62a, 64a of the busbars 62, 64 are covered by the cover 66. The cover 66 is attached to the inner wall of the casing 12. The cover 66 is constituted of an insulating material such as a resin. FIG. 8 shows a perspective view of the cover 66 with a lid 66c (see FIG. 6) removed. The cover 66 includes a cover portion 66a, a wall 66b, and the lid 66c.

The cover portion 66a holds the busbars 62, 64 by covering the body portions 62a, 64a. The cover portion 66a insulates the body portions 62a, 64a from the outside of the busbars 62, 64. As with the body portions 62a, 64a, the cover portion 66a is curved along the rotation direction R. The wall 66b is disposed on a face of the cover portion 66a that faces the inverter 20. The wall 66b protrudes perpendicular to the face of the cover portion 66a in a direction in which the end portions 62b, 64b, 62c, 64c extend from the face of the cover portion 66a. The wall 66b extends along the entire outer edge of the face of the cover portion 66a. An opening defined by the wall 66b opposite to the cover portion 66a is closed by the lid 66c. The interface between the wall 66b and the lid 66c is sealed by a sealing member in a liquid-tight manner. A passage 66d for a coolant is defined by the face of the cover portion 66a, the wall 66b, and the lid 66c. The end portions 62b, 64b are separated from the passage 66d by a separation wall 66e protruding from the cover portion 66a. The end portions 62c, 64c are separated from the passage 66d by a separation wall 66f protruding from the cover portion 66a.

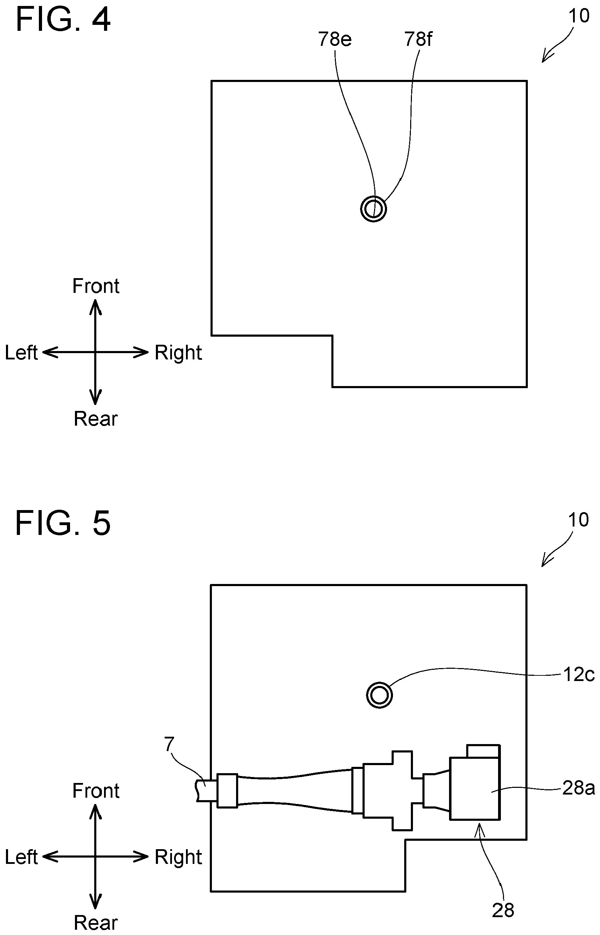

The passage 66d communicates with an inlet 66g at its upper end via a through hole defined in the wall 66b. The inlet 66g is defined in a cylindrical portion 66h located at an upper end of the cover portion 66a. The inlet 66g is located in an upper end portion of the busbar unit 60. The passage 66d communicates with an outlet 66j at its lower end via a through hole defined in the wall 66b. The outlet 66j is defined in a cylindrical portion 66k located at a lower end of the cover portion 66a. The outlet 66j is located in a lower end portion of the busbar unit 60. As shown in FIG. 5, the cylindrical portion 66k is connected to a communication pipe 12c disposed at the casing 12. The communication pipe 12c is disposed at the lower surface 12b. The outlet 66j communicates with the outside of the casing 12 via the communication pipe 12c.

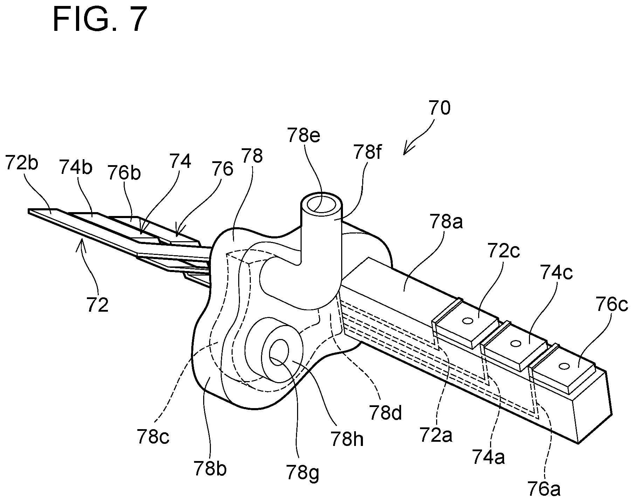

The busbar unit 70 extends from the power module 22 to the motor 14. As shown in FIG. 7, the busbar unit 70 includes three busbars 72, 74, 76 and a cover 78. The busbars 72, 74, 76 are constituted of the same conductive material as the busbars 62, 64. The busbars 72, 74, 76 each extend in the left-right direction from a position frontward of the power module 22 to a position frontward of and above the motor 14. The busbars 72, 74, 76 correspond to phases of three-phase AC. The busbars 72, 74, 76 electrically communicate between the power module 22 and the motor 14. The busbar 72 includes an end portion 72c electrically contacting the power module 22, an end portion 72b electrically contacting the motor 14, and a body portion 72a extending between the end portions 72b, 72c. As with the busbar 72, the busbars 74, 76 include end portions 74b, 76b, end portions 74c, 76c, and body portions 74a, 76a, respectively.

The end portions 72b, 74b, 76b are electrically connected to the stator 14d of the motor 14. The end portions 72c, 74c, 76c are electrically connected to the power module 22. The body portions 72a, 74a, 76a are covered by a cover 78. The cover 78 is attached to the inner wall of the casing 12. The cover 78 is constituted of the same insulating material as the cover 66. The cover 78 includes a cover portion 78a and a passage portion 78b.

The cover portion 78a holds the busbars 72, 74, 76 by covering the body portions 72a, 74a, 76a. The cover portion 78a insulates the body portions 72a, 74a, 76a from the outside of the busbars 72, 74, 76. As with the body portions 72a, 74a, 76a located frontward of the inverter 20, the cover portion 78a extends linearly in the left-right direction. The cover portion 78a has a quadrilateral prism shape. The passage portion 78b is located at an end of the cover portion 78a that is closer to the motor 14.

The passage portion 78b is formed integrally with the cover portion 78a. The passage portion 78b has a flattened shape extending from the end of the cover portion 78a to a position between the inverter 20 and the motor 14. The passage portion 78b has a space therein, which is shown by a broken line. The internal space of the passage portion 78b is a passage 78c in which a coolant flows. The passage 78c extends from the end of the cover portion 78a to a position between the inverter 20 and the motor 14. The busbars 72, 74, 76 penetrate the internal space of the passage portion 78b. The passage portion 78b includes a separation wall 78d surrounding the busbars 72, 74, 76 which penetrate the internal space. The busbars 72, 74, 76 are insulated from the passage 78c by the separation wall 78d.

The passage 78c communicates with an inlet 78e defined in the passage portion 78b, at its upper end. The inlet 78e is defined in a cylindrical portion 78f located at an upper end of the passage portion 78b. The cylindrical portion 78f extends from the passage portion 78b toward the inverter 20 along the left-right direction and bends upward at its middle position. The cylindrical portion 78f protrudes upward from the upper surface 12a of the casing 12. Specifically, the cylindrical portion 78f is located above a front end of the casing 12 and frontward of the uppermost end thereof. The passage 78c communicates with an outlet 78g defined in the passage portion 78b below the inlet 78e. The outlet 78g is defined in a cylindrical portion 78h located on the passage portion 78b. The cylindrical portion 78h extends from the passage portion 78b toward the inverter 20 along the left-right direction. The cylindrical portion 78h is connected to the cylindrical portion 66h via a communication pipe (not shown). Thus, the passage 78c communicates with the passage 66d via the outlet 78g and the inlet 66g.

### Coolant Flow

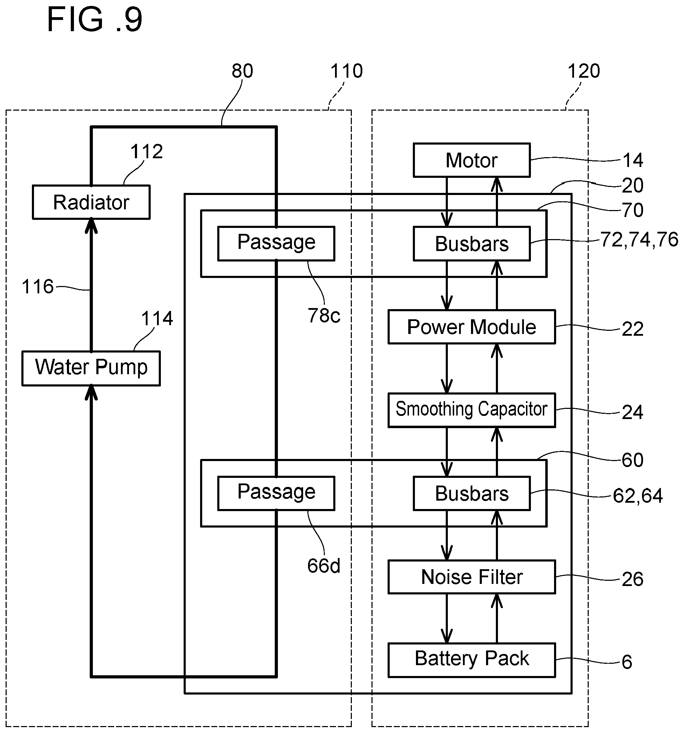

As shown in FIG. 2, a cooling unit 80 is located above the drive unit 10. As shown in FIG. 9, at least one cooling circuit 110 for cooling the motor 14 and the inverter 20 is mounted on the electric-powered vehicle 2. A coolant flow is shown with bold arrows in the cooling circuit 110. FIG. 9 shows a power supply order 120 indicating an order of supplying power between the battery pack 6 and the motor 14 through the inverter 20. The cooling unit 80 cools the power module 22 by the coolant flowing through the at least one cooling circuit 110. The cooling unit 80 is located above the power module 22. The coolant is a liquid coolant (i.e., LLC) for cooling one or more devices mounted on the electric-powered vehicle 2. Each cooling circuit 110 includes a pipe 116 in which the coolant flows, a radiator 112, and a water pump 114. The cooling unit 80 cools the power module 22 by the coolant flowing through the pipe around the power module 22.

The passages 66d, 78c of the busbar units 60, 70 are included in a cooling circuit for the inverter 20. Specifically, the inlet 78e is connected to a pipe extending from the cooling unit 80. Thus, the coolant in the cooling unit 80 flows into the passage 78c through the inlet 78e. In the passage 78c, the coolant flows downward from the inlet 78e and reaches the outlet 78g. The coolant flowing through the passage 78c cools the busbars 72, 74, 76 by exchanging heat with the body portions 72a, 74a, 76a of the busbars 72, 74, 76.

The coolant flows out from the outlet 78g and then flows into the passage 66d through the inlet 66g. In the passage 66d, the coolant flows downward from the inlet 66g and reaches the outlet 66j. The coolant flowing through the passage 66d exchanges heat with the busbars 62, 64 while flowing along the body portions 62a, 64a of the busbars 62, 64. Thus, the busbars 62, 64 are cooled. The coolant flows out from the outlet 66j and then flows into a pipe of the cooling unit 80 through the communication pipe 12c.

### Effects

The busbar unit 60 is configured to allow the coolant to flow along the body portions 62a, 64a of the busbars 62, 64. Thus, heat of the busbars 62, 64 can be efficiently released to the coolant. The same applies to the busbar unit 70, and thus heat of the busbars 72, 74, 76 can be efficiently released to the coolant.

In the busbar unit 60, the passage 66d for the coolant is integrally formed with the cover 66 which holds the busbars 62, 64. Thus, there is no need to provide a passage for coolant separately. The same applies to the busbar unit 70.

In the busbar unit 60, the inlet 66g is located at the upper end of the passage 66d and the outlet 66j is located at the lower end of the passage 66d. This configuration allows the coolant in the passage 66d to flow smoothly from the upper side to the lower side. The same applies to the busbar unit 70.

The inlet 78e of the busbar unit 70 is located to protrude upward from the upper surface 12a of the casing 12. This allows the inlet 78e to easily communicate with the pipe of the cooling unit 80 located above the drive unit 10. The cylindrical portion 78f in which the inlet 78e is defined is located above the front end of the casing 12 and frontward of the uppermost end thereof. This makes a space above the drive unit 10 available.

The cover 66 of the busbar unit 60 is located in a space between the inverter 20 and the motor 14. The cover 66 is curved along the rotation direction of the shaft gear 32. The busbars 62, 64 are also curved following the shape of the cover 66. The shape of the cover 66 is along the shape of the motor 14. Thus, the busbar unit 60 can be arranged about the shaft gear 32. Further, as shown in FIG.6, the busbar unit 60 substantially entirely overlaps the motor 14 as viewed in the direction along the center axis X. This allows for a reduction in the size of the drive unit 10. Thus, the space in the electric-powered vehicle 2 can be efficiently used.

The lower surface 12b of the casing 12 of the drive unit 10 is inclined upward from the front toward the rear. This configuration creates a space below the lower surface 12b. Thus, a space for components of the electric-powered vehicle 2 can be ensured. In the drive unit 10, the connector 28 connecting the battery pack 6 to the inverter 20 can be disposed below the lower surface 12b. The battery pack 6 is located below the floor panel of the electric-powered vehicle 2. The configuration above allows the connector 28 to be disposed near the battery pack 6. As a result, the power cable 7 can be shortened and a space for the power cable 7 can thus be reduced. The battery pack 6 may be at least partially disposed below the drive unit 10.

In the drive unit 10, the noise filter 26, the smoothing capacitor 24, and the power module 22 of the inverter 20 are arranged in this order from the lower side to the upper side, and thus the noise filter 26 is arranged near the connector 28. This allows wiring for supplying power from the connector 28 through the noise filter 26 and the smoothing capacitor 24 to the power module 22 in this order to be shortened.

In the drive unit 10, the power module 22, the smoothing capacitor 24, and the noise filter 26 overlap the motor 14 as viewed in the direction along the center axis X of the motor shaft 14b. This configuration allows the inverter 20 to be disposed in a space around the motor shaft 14b created by a dimensional difference between the motor 14 and the shaft gear 32, i.e., the diameter difference between them. Thus, the space created by the dimensional difference between the motor 14 and the shaft gear 32 can be efficiently used. In this configuration, the integration rate of the inverter 20 can be improved as compared to, for example, a configuration in which the inverter 20 is collectively disposed in a space above the motor 14, and thus the space can effectively be used.

As shown in FIG. 3, in a radial direction of the shaft gear 32, the inverter 20, i.e., the power module 22, the smoothing capacitor 24, and the noise filter 26, is arranged to overlap the shaft gear 32. As viewed in the left-right direction, the shaft gear 32 is surrounded by the power module 22, the smoothing capacitor 24, and the noise filter 26. The shaft gear 32 overlaps at least one of the power module 22, the smoothing capacitor 24, and the noise filter 26 in a radial direction of the shaft gear 32 over its entire length along the center axis X. Thus, the power module 22, the smoothing capacitor 24, and the noise filter 26 can be disposed in the space around the shaft gear 32 created by the dimensional difference between the motor 14 and the shaft gear 32. In a variant, the inverter 20, specifically any one of the power module 22, the smoothing capacitor 24, and the noise filter 26, may be arranged to at least partially overlap the shaft gear 32 in a radial direction of the shaft gear 32. For example, at least a part of the shaft gear 32 along the center axis X may not overlap any of the power module 22, the smoothing capacitor 24, and the noise filter 26 in a radial direction of the shaft gear 32.

The power module 22, the smoothing capacitor 24, and the noise filter 26 of the inverter 20 are arranged at different positions, and therefore the curved space around the shaft gear 32 can be efficiently used.

The maximum length of the power module 22 along the rotation direction R of the shaft gear 32 is greater than its maximum length along a radial direction of the shaft gear 32. Similarly, the maximum length of the smoothing capacitor 24 along the rotation direction of the shaft gear 32 is greater than its maximum length along a radial direction of the shaft gear 32. Similarly, the maximum length of the noise filter 26 along the rotation direction of the shaft gear 32 is greater than its maximum length along a radial direction of the shaft gear 32. In other words, the power module 22, the smoothing capacitor 24, and the noise filter 26 are arranged such that their longitudinal directions are along the rotation direction of the shaft gear 32 and their short directions are along radial directions of the shaft gear 32. This allows for efficient use of the space around the shaft gear 32 and suppresses expansion of the inverter 20 in radial directions of the shaft gear 32.

In the rotation direction of the shaft gear 32, the angle AN about the center axis X between the end 22b of the power module 22 which faces away from the smoothing capacitor 24 and the end 26b of the noise filter 26 which faces away from the smoothing capacitor 24 is more than or equal to 240 degrees. The angle AN may be more than or equal to 180 degrees. This configuration allows for efficient use of the space around the shaft gear 32.

Since most of the counter gear 34 and the counter gear 42 are located below the plane P connecting the center axis X of the motor shaft 14b and the center axis Y of the ring gear 50, a large space can be ensured for the inverter 20 above the plane P. An angular range of the space above the plane P about the center axis X is greater than an angular range of the space below the plane P about the center axis X.

The power module 22 and the counter gear 34 are arranged opposite to each other with the shaft gear 32 interposed therebetween. The diameter of the counter gear 34 is larger than that of the shaft gear 32 in order to provide the function of reducing the speed of the motor 14. Further, the power module 22 has the largest size among the components of the inverter 20. Since the power module 22 and the counter gear 34 both having large sizes are arranged opposite to each other with the shaft gear 32 interposed therebetween, the power module 22 and the counter gear 34 can be arranged without interference. The shaft gear 32 has the smallest diameter among the plurality of gears of the gear unit 30. Thus, arranging the power module 22, the smoothing capacitor 24, and the noise filter 26 around the shaft gear 32 allows the outer size of the drive unit 10 to be reduced as compared to a configuration in which they are arranged around a gear other than the shaft gear 32 among the plurality of gears of the gear unit 30.

While specific examples of the present disclosure have been described above in detail, these examples are merely illustrative and place no limitation on the scope of the patent claims. The technology described in the patent claims also encompasses various changes and modifications to the specific examples described above. Variants of the above embodiment are described below.

(Variant 1) The drive unit 10 may be located in a rear end portion of the vehicle. In this case, the lower surface 12b of the drive unit 10 may be inclined upward toward the center of the electric-powered vehicle 2 in the front-rear direction, i.e., toward the front of the electric-powered vehicle 2. The connector 28 may be located below the front end of the drive unit 10 and frontward of the lowermost end thereof. Further, the inlet 78e may be located above the rear end of the drive unit 10 and rearward of the uppermost end thereof.

(Variant 2) In the embodiment, the power module 22, the smoothing capacitor 24, and the noise filter 26 are arranged adjacent to each other along the rotation direction R. However, at least two of the power module 22, the smoothing capacitor 24, and the noise filter 26 may be arranged adjacent to each other in a radial direction of the shaft gear 32. Alternatively, at least two of the power module 22, the smoothing capacitor 24, and the noise filter 26 may be arranged adjacent to each other in the direction along the center axis X, i.e., in the left-right direction. For example, the power module 22, the smoothing capacitor 24, and the noise filter 26 may be collectively arranged above the shaft gear 32.

(Variant 3) The number of gears of the gear unit 30 is not limited. In the embodiment, the rotational speed of the motor 14 is reduced in two steps, however, the rotational speed of the motor 14 may be reduced in three steps. In this case, the gear unit 30 may include at least eight gears. The shaft gear 32 may have the smallest diameter among the plurality of gears of the gear unit 30.

(Variant 4) In either one of the busbar units 60, 70, the coolant passage may not be defined in the cover 66, 78. In this case, the coolant passage may be located at a position different from the cover 66, 78.

(Variant 5) The busbar unit 60 may not be curved along the rotation direction R. For example, the busbar unit 60 may be formed linearly.

(Variant 6) At least one of the busbar units 60, 70 may be used in an electric device other than the electric-powered vehicle 2. Especially, it may be used for a busbar used in an environment associated with at least one of large current and high temperature.

The technical elements explained in the present description or drawings provide technical utility either independently or through various combinations. The present disclosure is not limited to the combinations described at the time the claims are filed. Further, the purpose of the examples illustrated by the present description or drawings is to satisfy multiple objectives simultaneously, and satisfying any one of those objectives gives technical utility to the present disclosure.

## Claims

1. A busbar unit (60, 70) comprising:
a busbar (62, 64, 72, 74,76) through which an electric current flows; and
a cover (66, 78) covering an intermediate part of the busbar (62, 64, 72, 74,76),
wherein the cover (66, 78) comprises a passage (66d, 78c) along the intermediate part of the busbar (62, 64, 72, 74,76), a coolant for a vehicle (2) flowing in the passage (66d, 78c).

2. The busbar (60, 70) unit as in claim 1, wherein the coolant flowing in the passage (66d, 78c) is used for cooling a power module (22) mounted on the vehicle (2).

3. The busbar unit (60, 70) as in claim 1 or 2, wherein
the busbar unit (60, 70) is used in an inverter (20) used for controlling a drive motor (14) of the vehicle (2),
the inverter (20) comprises a power module (22) including a plurality of switching elements, a smoothing capacitor (24), and a noise filter (26),
the power module (22), the smoothing capacitor (24), and the noise filter (26) are arranged in this order from an upper side to a lower side, and
the passage (66d, 78c) is arranged to extend from the upper side toward the lower side.

4. The busbar unit (60, 70) as in claim 3, wherein
the busbar unit (60, 70) is housed in a casing (12) that covers the inverter (20), and
an outlet (78g) through which the coolant flows out from the passage (66d, 78c) is open to an outside of the casing (12).

5. The busbar unit (60) as in any one of claims 1 to 4, wherein the busbar (62, 64) and the cover (66) are curved along a shaft of a drive motor (14) of the vehicle (2).
